(19) Europäisches Patentamt
European Patent Office
Office européen des brevets

(11) EP 1 433 255 B1

(12) # EUROPÄISCHE PATENTSCHRIFT

(45) Veröffentlichungstag und Bekanntmachung des Hinweises auf die Patenterteilung:
**02.03.2011 Patentblatt 2011/09**

(21) Anmeldenummer: **02800117.0**

(22) Anmeldetag: **25.09.2002**

(51) Int Cl.:
***H03K 17/00*** *(2006.01)*

(86) Internationale Anmeldenummer:
**PCT/EP2002/010725**

(87) Internationale Veröffentlichungsnummer:
**WO 2003/030364 (10.04.2003 Gazette 2003/15)**

(54) **STEUERGERÄT**

CONTROL DEVICE

APPAREIL DE COMMANDE

(84) Benannte Vertragsstaaten:
**AT BE BG CH CY CZ DE DK EE ES FI FR GB GR IE IT LI LU MC NL PT SE SK TR**

(30) Priorität: **28.09.2001 DE 10149390**

(43) Veröffentlichungstag der Anmeldung:
**30.06.2004 Patentblatt 2004/27**

(73) Patentinhaber: **Flextronics International Kft.**
**Tab 8660 (HU)**

(72) Erfinder: **HERKE, Dirk**
**72622 Nürtingen (DE)**

(74) Vertreter: **Rupprecht, Kay et al**
**Meissner, Bolte & Partner GbR**
**Widenmayerstraße 48**
**80538 München (DE)**

(56) Entgegenhaltungen:
**DE-A- 19 743 346**
**DE-A- 19 814 681**
**DE-A- 19 941 488**
**US-A- 5 420 532**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 433 255 B1

**Beschreibung**

Die Erfindung betrifft ein Steuergerät zum Betreiben eines eine induktive Last aufweisenden Lastkreises, umfassend eine Steuerstufe, die ein pulsweitenmoduliertes Steuersignal erzeugt, welches durch vorgesehene Messausschaltintervalle unterbrochen wird, eine den Lastkreis speisende Leistungsstufe mit einem durch das pulsweitenmodulierte Steuersignal angesteuerten elektronischen Schalter und mit einem Freilaufelement, dem ein Lastkreis parallelgeschaltet werden kann.

Derartige Steuergeräte sind aus dem Stand der Technik, beispielsweise der EP 0 855 799 A2 bekannt.

Bei diesen bislang bekannten Steuergeräten erfolgt eine Bestimmung des in den Lastkreis fließenden Stroms entweder über einen Shunt-Widerstand oder einen Messverstärker, die beide aufwendig zu realisieren sind. Bei einem Shunt-Widerstand kommt noch hinzu, dass dieser den Wirkungsgrad verschlechtert und Wärme erzeugt.

Aus der DE 197 43 346 A1 ist ein Steuergerät bekannt, das einen Messverstärker parallel zum Freilaufelement aufweist, der den Strom durch das Freilaufelement während des Offenzustandes des pulsweitenmodulierten Steuersignals erfasst.

Der Erfindung liegt die Aufgabe zugrunde, ein Steuergerät der gattungsgemäßen Art derart zu verbessern, dass in einfacher Weise eine Bestimmung des in den Lastkreis fließenden Stromes möglich ist.

Diese Aufgabe wird bei einem Steuergerät der eingangs beschriebenen Art erfindungsgemäß dadurch gelöst, dass eine Stromerfassungseinheit zur Bestimmung des vor dem Messausschaltintervall in den Lastkreis fließenden Stroms in dem Messausschaltintervall die Dauer der Freilaufzeit erfasst und aus dieser den Strom errechnet.

Der Vorteil dieser Lösung ist darin zu sehen, daß diese mit einfachen und kostengünstigen Mitteln die Bestimmung des in den Lastkreis fließenden Stromes erlaubt.

Hinsichtlich der Messung der Freilaufzeit sind die unterschiedlichsten Möglichkeiten denkbar. Beispielsweise wäre es denkbar, durch Spannungsabtastungen die Zeit zu ermitteln, während welcher eine Freilaufspannung kleiner Null im Meßausschaltintervall vorliegt. Dies würde jedoch eine hohe Zahl von Abtastungen erfordern.

Aus diesem Grund sieht ein besonders günstiges Ausführungsbeispiel vor, daß die Stromerfassungseinheit die Freilaufzeit über eine Integrationsstufe erfaßt, welche einen Referenzwert über die Freilaufzeit integriert. Damit ist eine einfache Möglichkeit geschaffen, die Freilaufzeit mittels eines einfach meßbaren Wertes zu erfassen.

Besonders einfach läßt sich die Integrationsstufe dann betreiben, wenn während der Zeit, während der die Spannung im Lastkreis kleiner Null ist, die Integrationsstufe durch einen durch die Spannung im Lastkreis gesteuerten Schalter aktiviert ist.

Ein derartiger Schalter läßt sich im einfachsten Fall als Schalttransistor ausführen, dessen Basis durch die Spannung im Lastkreis gesteuert ist.

Hinsichtlich der Ausbildung der Integrationsstufe selbst wurden bislang keine näheren Angaben gemacht.

So sieht eine besonders einfache Lösung vor, daß die Integrationsstufe eine Integration einer Spannung als Referenzwert über die Freilaufzeit durchführt, da Spannungen als Referenzwerte bei dem erfindungsgemäßen Steuergerät in einfacher Weise generierbar sind und außerdem integrierte Spannungen in einfacher Weise meßbar sind.

Hinsichtlich der schaltungstechnischen Ausbildung der Integrationsstufe selbst wurden bislang keine näheren Angaben gemacht. So sieht eine besonders günstige Lösung vor, daß die Integrationsstufe ein RC-Glied umfaßt.

Mit einem derartigen RC-Glied läßt sich die Integrationsstufe besonders einfach und kostengünstig realisieren.

Bei einem derartigen RC-Glied läßt sich die Integration besonders günstig dadurch durchführen, daß das Aufladen des Kondensators des RC-Gliedes über einen durch die Spannung im Lastkreis ansteuerbaren elektronischen Schalter gesteuert wird.

Um mit der Integrationsstufe immer wieder neue Integrationen starten zu können, ist vorzugsweise vorgesehen, daß der in der Integrationsstufe gespeicherte Wert nach Beendigung des Meßausschaltintervalls gelöscht wird.

Besonders einfach läßt sich dieses Löschen dadurch realisieren, daß der in der Integrationsstufe gespeicherte Wert durch das wiederauftretende pulsweitenmodulierte Steuersignal gelöscht wird.

Besonders einfach läßt sich dies dadurch realisieren, daß die Löschung durch ein Einschaltintervall des pulsweitenmodulierten Steuersignals erfolgt.

Um in einfacher Weise den von der Integrationsstufe gemessenen Wert für die Freilaufzeit auswerten zu können, ist vorzugsweise vorgesehen, daß die Integrationsstufe den bei der Integration ermittelten Wert bis zur Beendigung des Meßausschaltintervalls hält.

Im Rahmen der bislang beschriebenen erfindungsgemäßen Lösungen wurde lediglich davon ausgegangen, daß die im Lastkreis vorhandene induktive Last einen Freilaufstrom erzeugt.

Ist jedoch die induktive Last ein Elektromotor, so erzeugt dieser in dem Meßausschaltintervall auch noch eine Generatorspannung, die Einfluß auf die gemessene Freilaufzeit hat und somit auch bei der Errechnung des in den Lastkreis fließenden Stroms zu berücksichtigen ist.

Aus diesem Grund ist bei einem Ausführungsbeispiel des erfindungsgemäßen Steuergeräts, bei welchem die induktive Last im Lastkreis ein Elektromotor ist, die Stromerfassungseinheit so ausgebildet, daß sie zur Bestimmung des Motorstroms in dem Meßausschaltintervall die Dauer der Freilaufzeit und den Plateauwert der Generatorspannung nach der Freilaufzeit mißt.

Mit diesen Größen ist die Stromerfassungseinheit ebenfalls in der Lage, den Strom in den Laststromkreis vor Auftreten des Meßausschaltintervalls zu bestimmen.

Hinsichtlich der Bestimmung des Plateauwerts der Generatorspannung sind unterschiedliche Lösungen denkbar. So wäre es beispielsweise denkbar, nach Ablauf der Freilaufzeit die Spannung im Meßausschaltintervall zu erfassen, wobei das Problem besteht, Verfälschungen der Generatorspannung, die durch alle Arten von Störungen auftreten können, zu eliminieren.

Ausreichend präzise läßt sich der Plateauwert der Generatorspannung nach der Freilaufzeit dann ermitteln, wenn die Stromerfassungseinheit die Generatorspannung im Plateaubereich durch mehrere Spannungsabtastungen mißt.

Durch diese mehreren Spannungsabtastungen läßt sich die Präzision der Messung erhöhen.

Besonders günstig ist es dabei, wenn die Stromerfassungseinheit eine Mittelung der bei den mehreren Spannungsabtastungen gemessenen Werte durchführt.

Prinzipiell wäre es denkbar, daß die Stromerfassungseinheit stets entsprechend der die Freilaufzeit und gegebenenfalls die Generatorspannung mit dem Strom verknüpfenden Formel den Strom ausrechnet.

Dies erfordert jedoch einen erheblichen Rechenaufwand und damit selbst bei hierfür nicht geeigneten Prozessoren eine erhebliche Rechenzeit.

Aus diesem Grund ist es besonders günstig, wenn die Stromerfassungseinheit bei der Ermittlung des Stroms mittels dem erfaßten Maß für die Freilaufzeit einen Wert aus einer Tabelle entnimmt, mit welchem sich durch Multiplikation der Strom ermitteln läßt.

Das heißt, daß die Stromerfassungseinheit, insbesondere deren Prozessor, nicht die gesamte mathematische Formel stets ausrechnen muß, sondern daß die Rechenarbeit bei der Erstellung der Tabelle erfolgt und somit der Prozessor der Stromerfassungseinheit lediglich den der dem Maß der Freilaufzeit entsprechenden Wert aus der Tabelle auslesen muß und mit diesem Wert lediglich noch eine Multiplikation, beispielsweise eine Multiplikation mit der an dem Freitaufetement abfallenden konstanten Spannung oder gegebenenfalls der Summe aus dieser Spannung und der Generatorspannung, durchführen muß, um den Wert für den Strom zu erhalten.

Damit wird der Rechenaufwand und somit auch die Rechenzeit bei der Bestimmung des Stroms erheblich reduziert, so daß im Zusammenhang mit jedem Meßausschaltintervall in einfacher Weise und auch mit einfachen Prozessoren der Wert für den Strom bestimmt werden kann.

Mit der erfindungsgemäßen Lösung lassen sich somit die bei der Ermittlung des Stroms während des Meßausschaltintervalls erforderlichen Rechenoperationen auch im Fall eines Elektromotors, der eine Generatorspannung erzeugt, auf eine Addition und eine Multiplikation reduzieren und im Fall einer induktiven Last, die keine Generatorspannung erzeugt, auf eine reine Multiplikation.

Weitere Merkmale und Vorteile der Erfindung sind Gegenstand der nachfolgenden Beschreibung sowie der zeichnerischen Darstellung eines Ausführungsbeispiels einer erfindungsgemäßen Lösung.

In der Zeichnung zeigen:

Fig. 1 ein schematisches Blockschaltbild eines erfindungsgemäßen Steuergeräts;

Fig. 2 eine Darstellung des Verhaltens der Spannung am Freilauf- element und des Freilaufstroms in einem Meßausschalt- intervall;

Fig. 3 eine schematische Darstellung einer Integrationsstufe mit Auswertung bei der erfindungsgemäßen Stromerfassungs- einheit und

Fig. 4 eine Darstellung einer Spannung $U_{INT}$ über dem Verlauf der Spannung am Freilaufelement.

Ein Ausführungsbeispiel eines erfindungsgemäßen Steuergeräts, in Fig. 1 als Ganzes mit 10 bezeichnet, betreibt einen Lastkreis 12 mit einer induktiven Last, die im dargestellten Ausführungsbeispiel ein Elektromotor M ist.

Erfindungsgemäß kann jedoch in dem Lastkreis 12 auch jede anders geartete induktive Last, also beispielsweise auch ein Elektromagnet oder eine Heizspule vorgesehen sein.

Zum Betreiben der induktiven Last M umfaßt das Steuergerät 10 eine Steuerstufe 14, welche ein pulsweitenmoduliertes Steuersignal SPWM erzeugt, mit welchem eine Leistungsstufe 16 ansteuerbar ist, die ihrerseits einen durch das pulsweitenmodulierte Steuersignal SPWM steuerbaren elektronischen Schalter 18 umfaßt, der beispielsweise als Feldeffekttransistor ausgebildet sein kann.

Mit diesem durch das Steuersignal SPWM gesteuerten elektronischen Schalter 18 wird eine dem Steuersignal SPWM vom Zeitverlauf her entsprechende, beispielsweise invertierte, pulsweitenmodulierte Speisespannung PWM erzeugt, mit welcher über eine Anschlußklemme 20 des Lastkreises 12 eine Speisung der in diesem vorhandenen induktiven Last M erfolgt.

Zwischen der Anschlußklemme 20 und Masse liegt ferner noch ein als Ganzes mit 22 bezeichnetes Freilaufelement, beispielsweise eine Freilaufdiode ist, die beim Abschalten der pulsweitenmodulierten Speisespannung PWM den von der Induktivität M erzeugten Freilaufstrom $I_F$ übernimmt.

Das Freilaufelement 22 kann aber auch ein synchron zum pulsweitenmodulierten Steuersignal SPWM gesteuerter elektronischer Schalter sein.

Ferner umfaßt das erfindungsgemäße Steuergerät 10 eine Stromerfassungseinheit 24, deren Eingang 26 mit der Anschlußklemme 20 verbunden ist, so daß diese in der Lage ist, eine im Lastkreis 12 anliegende Spannung U zu erfassen.

Die Stromerfassungseinheit 24 weist ferner noch einen Anschluß 28 auf, mit welchem diese das pulsweitenmodulierte Steuersignal SPWM erfaßt.

Ferner kommuniziert die Stromerfassungseinheit 24 noch mit der Steuerstufe 14 und veranlaßt diese, das pulsweitenmodulierte Steuersignal SPWM durch Meßausschaltintervalle zu unterbrechen, so daß bei der Speisung des Lastkreises 12 die pulsweitenmodulierte Speisespannung PWM ebenfalls durch ein derartiges Meßausschaltintervall MAI unterbrochen wird.

Bei einer Unterbrechung der Speisung des Lastkreises 12 führt die im Lastkreis 12 vorhandene Induktivität zu einem über das Freilaufelement 22 fließenden Freilaufstrom $I_F$, welcher ungefähr exponentiell abfällt und während einer Freilaufzeit F fließt.

Während dieser Freilaufzeit F ist die an der Klemme 20 des Lastkreises 12 gemessene Freilaufspannung $U_F$ kleiner Null.

Im Fall einer Induktivität in Form einer Spule oder eines Magneten oder einer Heizung tritt innerhalb des jeweiligen Meßausschaltintervalls MAI nach Ablauf der Freilaufzeit F im Lastkreis 12 keine Spannung mehr auf.

Die erfindungsgemäße Stromerfassungseinheit 24 arbeitet in diesem Fall so, daß sie die Freilaufzeit F erfaßt, denn diese ist ein Maß für den Strom, der während der Zeit der eingeschalteten pulsweitenmodulierten Speisespannung PWM in den Lastkreis 12 geflossen ist.

Ist dagegen in dem Lastkreis 12 ein Elektromotor M als induktive Last vorgesehen, so erzeugt dieser Elektromotor M nach Abschalten der pulsweitenmodulierten Speisespannung PWM in dem Meßausschaltintervall MAI eine Generatorspannung $U_G$. Diese ist im Fall des Elektromotors M als induktive Last im Lastkreis 12 zu berücksichtigen und wirkt sich auch auf den Freilaufstrom $I_E$ und die Freilaufzeit F aus. Der Freilaufstrom $I_F$ baut sich in diesem Fall an der entgegengesetzten Generatorspannung $U_G$, an dem Freilaufelement 22 und am Innenwiderstand des Elektromotors M ab, wobei dann wenn $I_F$ fließt $U_F$ der Diodenspannung des Freilaufelements 22 entspricht.

Die Generatorspannung $U_G$ ist insbesondere abhängig vom Aufbau des Elektromotors M, und von dessen Drehzahl.

Die Generatorspannung $U_G$ ist innerhalb des jeweiligen Meßausschaltintervalls MAI nach Beendigung der Freilaufzeit F meßbar und nimmt ausgehend von dem Wert Null bis zu einem Plateauwert $U_{GMAX}$ zu, wobei nach Ausbildung des Plateauwertes $U_{GMAX}$ die Generatorspannung $U_G$ über das ganze Plateau P im wesentlichen über der Zeitachse t konstant sein sollte, wenn keine Störungen diesen Plateauwert $U_{GMAX}$ verfälschen.

Grundsätzlich ist es möglich, die Freilaufzeit F dadurch zu messen, daß geprüft wird, wie lange die Spannung U über dem Freilaufelement 22 der Diodenspannung von beispielsweise -0,7 V entspricht.

In diesem Fall läßt sich der Laststrom Last wie folgt berechnen:

$$I_{Last} = \frac{\frac{(U_{GMAX} + U_D)}{R_L}\left(1 - e^{-\frac{R_L}{L_L}F}\right)}{-e^{-\frac{R_L}{L_L}F}}$$

Dabei bedeutet

| | |
|---|---|
| $U_{GMAX}$ | die zu messende Generatorspannung |
| F | die zu messende Freilaufzeit |
| $U_D$ | die am Freilaufelement 22 abfallende Spannung |
| $R_L$ | der Ohm'sche Widerstand im Lastkreis 12 |
| $L_L$ | die Induktivität des Lastkreises 12 |

Da die Dauer der Freilaufzeit F problematisch zu messen ist, wird vorzugsweise erfindungsgemäß in der Stromerfassungseinheit 24 zur Messung der Freilaufzeit F eine in Fig. 3 dargestellte Integrationsstufe 30 eingesetzt, welche ein zwischen einer Batteriespannung UB und Masse liegendes RC-Glied 32 umfaßt, dessen Kondensator C einerseits mit der stabilisierten Batteriespannung UB verbunden ist und andererseits über ein Mittelabgriff 34 mit dem Widerstand R, der über einen Schalttransistor T1 wiederum auf Masse gelegt werden kann.

Zum Aufladen des Kondensators C des RC-Glieds 32 ist die Basis des Transistors T1 mit dem Anschluß 26 und somit mit der Anschlußklemme 20 verbunden, wobei zwischen dem Anschluß 26 und der Basis des Schalttransistors T1 ein Basiswiderstand RB vorgesehen ist.

Wird der Schalttransistor T1 durchgesteuert, so erfolgt über den Widerstand R, der bei durchgeschaltetem Schalttransistor T1 auf Masse liegt, ein Aufladen des Kondensators C, wobei ein das Ergebnis einer Integration darstellende Spannung $U_{INT}$ am Mittelabgriff 34 zunächst bei entladenem Kondensator C der Batteriespannung $U_B$ entspricht und mit zunehmender Aufladung des Kondensators C absinkt, wie schematisch in Fig. 3 und als Messung in Fig. 4 dargestellt.

Diese Spannung $U_{INT}$ am Mittelabgriff 34 wird beispielsweise von einem A/D-Wandler 36 zu einem Zeitpunkt $t_w$ in einen digitalen Wert umgewandelt, wobei der Zeitpunkt $t_w$ innerhalb des Meßausschaltintervalls MAF so gelegt ist, daß die Erfassung von $U_{INT}$ durch Wandlung in einen digitalen Wert mit Sicherheit nach Beendigung der maximal möglichen Freilaufzeit erfolgt.

Um den im Kondensator C gespeicherten Spannungswert $U_{INT}$ zu löschen, liegt zwischen dem Mittelabgriff 34 und der Batteriespannung $U_B$ ein Schalttransistor T2, dessen Basis über einen Basiswiderstand RB2 durch das pulsweitenmodulierte Steuersignal SPWM angesteuert ist, wobei bei diesem Fall das pulsweitenmodulierte Steuersignal SPWM invertiert zur pulsweitenmodulierten Speisespannung PWM ist (Fig. 3).

Dieses pulsweitenmodulierte Steuersignal SPWM liegt am Anschluß 28 der Stromerfassungseinheit 24 an.

Der Schalttransistor T2 wird jeweils bei einer Einschaltflanke der pulsweitenmodulierten Speisespannung PWM durchgeschaltet und entlädt den Kondensator C somit zum Zeitpunkt $t_L$ (Fig. 4).

Die Integrationsstufe 30 läuft auch bei der normalen pulsweitenmodulierten - Speisespannung PWM ebenfalls mit und integriert während der Ausschaltintervalle der pulsweitenmodulierten Speisespannung PWM einen Wert, der jedoch bei den Einschaltintervallen der pulsweitenmodulierten Speisespannung PWM wieder durch den Schalttransistor T2 gelöscht wird.

Bei einem Meßausschaltintervall MAI erfolgt während der Zeit, während der die Freilaufspannung $U_F$ anliegt und somit die Spannung U über dem Freilaufelement 22 negativ ist, ein Durchschalten des Schalttransistors T1 und somit während der Freilaufzeit F, bis zu dem Zeitpunkt, zu dem die Freilaufspannung $U_F$ gleich Null wird, ein Aufladen des Kondensators C und somit eine Absenkung der an dem Mittelabgriff 34 anliegenden Spannung $U_{INT}$. Der abgesenkte Wert, den die Spannung $U_{INT}$ bis zum Ende der Freilaufzeit F den Mittelabgriff 34 erreicht stellt das Maß für die Dauer der Freilaufzeit F dar.

Dieser Wert $U_{INT}$ wird vom Kondensator C so lange gehalten, bis die nächste Einschaltflanke der pulsweitenmodulierten Speisespannung PWM zum Zeitpunkt $t_L$ auftritt.

Zur Messung der maximalen Generatorspannung $U_{GMAX}$ ist mit dem Anschluß 26 gleichzeitig noch ein A/D-Wandler 38 verbunden und die beiden A/D-Wandler 36 und 38 der Stromerfassungseinheit 24 sind mit einem Prozessor 40 der Stromerfassungseinheit 24 gekoppelt, der die Auswertung vornimmt und den Laststrom ermittelt.

Die Messung der maximalen Generatorspannung $U_{GMAX}$ erfolgt mit dem A/D-Wandler 38 zu zwei Zeitpunkten $t_1$ und $t_2$ in dem Bereich des Meßausschaltintervalls, in dem das Plateau P der Generatorspannung $U_G$ vorliegt, durch Spannungsabtastungen A1 und A2, wobei vorzugsweise ein Mittelwert der zu den Zeitpunkten $t_1$ und $t_2$ gemessenen Spannungen $U_{GMAX}$ gebildet wird, um Störungen zu eliminieren.

Es ist aber auch denkbar, mit dem A/D-Wandler 38 noch zu weiteren Zeitpunkten Spannungsabtastungen vorzunehmen und über mehrere Spannungsabtastungen dann eine mittlere Generatorspannung $U_{GMAX}$ zu ermitteln.

Der Prozessor 40 ist nun in der Lage, die Mittelwerte der vom A/D-Wandler 38 Spannungen $U_{GMAX}$ zu bestimmen und mit diesen und der vom A/D-Wandler 36 gewandelten Spannung $U_{INT}$, die ein Maß für die Freilaufzeit darstellt, den Laststrom $I_{LAST}$ zu errechnen.

Vorzugsweise ermittelt der Prozessor 40 den Laststrom $I_{Last}$ dabei gemäß der Formel

$$I_{Last} = (U_{GMAX} + U_D) \frac{\frac{1}{R_L}\left(1 - e^{\frac{R_L}{L_L}(-R)C \bullet \ln\frac{U_{INT}}{U_B}}\right)}{e^{-\frac{R_L}{L_L}(-R)C \bullet \ln\frac{U_{INT}}{U_B}}} \bullet k$$

Dabei bedeutet

| | |
|---|---|
| $I_{las}$ | der zu berechnende Laststrom |
| $U_{GMAX}$ | die zu messende Generatorspannung |
| $U_{int}$ | der im Kondensator C gespeicherte und zu messende Spannungswert |
| $U_D$ | die am Freilaufelement 22 abfallende Spannung, die konstant ist |
| $R_L$ | der Ohm'sche Widerstand im Lastkreis 12, die konstant ist |
| $L_L$ | die Induktivität des Lastkreises 12, die konstant ist |
| R | der Ohm'sche Widerstand des RC-Glieds 32, die konstant ist |
| C | die Kapazität des RC-Glieds 32, die konstant ist |
| $U_B$ | die stabilisierte Batteriespannung die am RC-Glied anliegt, die konstant ist |
| U | eine Motorkonstante, die konstant ist. |

Da lediglich die Generatorspannung $U_{GMAX}$ und der Spannungswert $U_{INT}$ variable Größen sind, die sich bei der Änderung von $I_{Last}$ auch ändern, besteht die Möglichkeit, die Berechnung von $I_{Last}$ zu vereinfachen und die Werte W des gesamten Ausdrucks

$$\frac{\frac{1}{R_L}\left(1 - e^{\frac{R_L}{L_L}(-R)C \bullet \ln\frac{U_{INT}}{U_B}}\right)}{e^{-\frac{R_L}{L_L}(-R)C \bullet \ln\frac{U_{INT}}{U_B}}} \bullet k = W$$

als von $U_{INT}$ abhängige Wertetabelle ablegen:

| $U_{INT1}$ | $U_{INT2}$ | $U_{INT3}$ | .... | $U_{INTn}$ |
|---|---|---|---|---|
| $W_1$ | $W_2$ | $W_3$ | - | $W_n$ |

so daß nach jeder Bestimmung von $U_{INT}$ der entsprechende Wert W aus der Tabelle ausgelesen werden kann und sich folglich komplizierte und zeitaufwendige Rechenvorgänge bei der Berechnung von $I_{Last}$ in dem jeweiligen Meßausschaltintervall erübrigen.

Beispielsweise werden zuerst die Spannungsabtastungen zu den Zeitpunkten $t_1$ und $t_2$ durchgeführt und daraus wird dann durch Mittelung $U_{GMAX}$ vom Prozessor 40 errechnet. Anschließend wird zum Zeitpunkt $t_w$ noch $U_{INT}$ - als Maß für die Freilaufzeit F - bestimmt und entsprechend der Formel $I_{Last} = (U_{GMAX}$- $+ U_D)$ W dann vom Prozessor 40 $I_{Last}$ errechnet.

Ist im Lastkreis 12 anstelle des Motors M nur eine Induktivität, beispielsweise in Form eines Magneten oder einer Spule vorhanden, so tritt keine Generatorspannung $U_G$ auf und die Generatorspannung $U_{GMAX}$ ist in der Formel gleich Null zu setzen.

Der Prozessor 40 ist somit nach jedem Meßausschaltintervall MAI in der Lage, den Strom $I_{Last}$ zu errechnen, der bei der vorausgegangenen pulsweitenmodulierten Speisespannung PWM in den Lastkreis 12 geflossen ist.

## Patentansprüche

1. Steuergerät zum Betreiben eines eine induktive Last (M) aufweisenden Lastkreises (12), umfassend eine Steuerstufe (14), die ein pulsweitenmoduliertes Steuersignal (SPWM) erzeugt, welches durch vorgesehene Messausschaltintervalle (MAI) unterbrochen wird, eine den Lastkreis (12) speisende Leistungsstufe (16) mit einem durch das pulsweitenmodulierte Steuersignal (SPWM) angesteuerten elektronischen Schalter (18) und mit einem Freilaufelement (22), dem ein Lastkreis (12) parallelgeschaltet werden kann,
**dadurch gekennzeichnet, dass** eine Stromerfassungseinheit (24) zur Bestimmung des vor dem Messausschaltintervall (MAI) in den Lastkreis fließenden Stroms ($I_{Last}$) in dem Messausschaltintervall (MAI) die Dauer der Freilaufzeit (F) erfasst und aus dieser den Strom ($I_{Last}$) errechnet.

**2.** Steuergerät nach Anspruch 1, **dadurch gekennzeichnet, dass** die Stromerfassungseinheit (24) die Freilaufzeit (F) über eine Integrationsstufe (30) erfasst, welche einen Referenzwert ($U_B$) über die Freilaufzeit (F) integriert.

**3.** Steuergerät nach Anspruch 2, **dadurch gekennzeichnet, dass** die Integrationsstufe (30) während der Zeit, während der die Spannung (U) im Lastkreis (12) kleiner Null ist, durch einen durch die Spannung (U) im Lastkreis (12) gesteuerten elektronischen Schalter (T1) aktiviert ist.

**4.** Steuergerät nach Anspruch 2 oder 3, **dadurch gekennzeichnet, daß** die Integrationsstufe (30) eine Integration einer Spannung ($U_B$) als Referenzwert über die Freilaufzeit (F) durchführt.

**5.** Steuergerät nach einem der Ansprüche 2 bis 4, **dadurch gekennzeichnet, daß** die Integrationsstufe (30) ein RC-Glied (32) umfaßt.

**6.** Steuergerät nach Anspruch 5, **dadurch gekennzeichnet, daß** das Aufladen des Kondensators (C) des RC-Gliedes (32) über einen durch die Spannung (U) im Lastkreis (12) ansteuerbaren elektronischen Schalter (T1) gesteuert wird.

**7.** Steuergerät nach einem der Ansprüche 2 bis 6, **dadurch gekennzeichnet, daß** der in der Integrationsstufe (30) gespeicherte Wert ($U_{INT}$) nach Beendigung des Meßausschaltintervalls (MAI) gelöscht wird.

**8.** Steuergerät nach Anspruch 7, **dadurch gekennzeichnet, daß** der in der Integrationsstufe (30) gespeicherte Wert ($U_{INT}$) durch das wiederauftretende pulsweitenmodulierte Steuersignal (SPWM) gelöscht wird.

**9.** Steuergerät nach Anspruch 8, **dadurch gekennzeichnet, daß** die Löschung durch ein Einschaltintervall des pulsweitenmodulierten Steuersignal (SPWM) erfolgt.

**10.** Steuergerät nach einem der Ansprüche 2 bis 9, **dadurch gekennzeichnet, daß** die Integrationsstufe (30) den bei der Integration ermittelten Wert ($U_{INT}$) bis zur Beendigung des Meßausschaltintervalls (MAI) hält.

**11.** Steuergerät nach einem der voranstehenden Ansprüche, **dadurch gekennzeichnet, daß** bei einem Elektromotor (M) als induktive Last im Lastkreis (12) die Stromerfassungseinheit (24) zur Bestimmung des in den Lastkreis (12) fließenden Stroms ($I_{Last}$) in den Meßausschaltintervall (MAI) die Dauer der Freilaufzeit (F) und den Plateauwert ($U_{GMAX}$) der Generatorspannung ($U_G$) nach der Freilaufzeit (F) mißt.

**12.** Steuergerät nach Anspruch 11, **dadurch gekennzeichnet, daß** die Stromerfassungseinheit (24) die Generatorspannung ($U_{GMAX}$) im Plateaubereich (P) durch mehrere Spannungsabtastungen (A1, A2) mißt.

**13.** Steuergerät nach Anspruch 12, **dadurch gekennzeichnet, daß** die Stromerfassungseinheit (24) eine Mittelung der bei den mehreren Spannungsabtastungen (A1, A2) gemessenen Spannungen (U) durchführt.

**14.** Steuergerät nach einem der voranstehenden Ansprüche, **dadurch gekennzeichnet, daß** die Stromerfassungseinheit (24) bei der Ermittlung des Stroms ($I_{Last}$) mittels dem erfaßten Maß für die Freilaufzeit (F) einen Wert (W) aus einer Tabelle bestimmt, mit welchem sich durch Multiplikation der Strom ($I_{Last}$) ermitteln läßt.

## Claims

**1.** Control device for operating a load circuit (12) having an inductive load (M), comprising a control stage (14) that generates a pulse width modulated control signal (SPWM) which is interrupted by intended measurement disconnection intervals (MAI), a power stage (16) supplying the load circuit (12) and having an electronic switch (18) driven by the pulse width modulated control signal (SPWM), and having a freewheel element (22) in parallel with which a load circuit (12) can be connected,
**characterised in that**, in order to determine the current ($I_{load}$) flowing into the load circuit before the measurement disconnection interval (MAI), a current detection unit (24) detects the duration of the freewheeling time (F) in the measurement disconnection interval (MAI) and calculates the current ($I_{load}$) therefrom.

**2.** Control device according to Claim 1, **characterised in that** the current detection unit (24) detects the freewheeling time (F) by means of an integration stage (30) which integrates a reference value ($U_B$) over the freewheeling time (F).

**3.** Control device according to Claim 2, **characterised in that** the integration stage (30) is activated for the time during which the voltage (U) in the load circuit (12) is less than zero, by an electronic switch (T1) controlled by the voltage (U) in the load circuit (12).

**4.** Control device according to Claim 2 or 3, **characterised in that** the integration stage (30) carries out integration of a voltage ($U_B$) as a reference value over the freewheeling time (F).

**5.** Control device according to one of Claims 2 to 4, **characterised in that** the integration stage (30) comprises an RC component (32).

**6.** Control device according to Claim 5, **characterised in that** the charging of the capacitor (C) of the RC component (32) is controlled by means of an electronic switch (T1) which can be driven by the voltage (U) in the load circuit (12).

**7.** Control device according to one of Claims 2 to 6, **characterised in that** the value ($U_{INT}$) stored in the integration stage (30) is erased after the end of the measurement disconnection interval (MAI).

**8.** Control device according to Claim 7, **characterised in that** the value ($U_{INT}$) stored in the integration stage (30) is erased by the recurring pulse width modulated control signal (SPWM).

**9.** Control device according to Claim 8, **characterised in that** the erasing is carried out by a connection interval of the pulse width modulated control signal (SPWM).

**10.** Control device according to one of Claims 2 to 9, **characterised in that** the integration stage (30) keeps the value ($U_{INT}$) determined during the integration until the end of the measurement disconnection interval (MAI).

**11.** Control device according to one of the preceding claims, **characterised in that** in the case of an electric motor (M) as an inductive load in the load circuit (12), in order to determine the current ($I_{load}$) flowing into the load circuit in the measurement disconnection interval (MAI), the current detection unit (24) measures the duration of the freewheeling time (F) and the plateau value ($U_{GMAX}$) of the generator voltage ($U_G$) after the freewheeling time (F).

**12.** Control device according to Claim 11, **characterised in that** the current detection unit (24) measures the generator voltage ($U_{GMAX}$) in the plateau region (P) by a plurality of voltage samplings (A1, A2).

**13.** Control device according to Claim 12, **characterised in that** the current detection unit (24) carries out averaging of the voltages (U) measured in the plurality of voltage samplings (A1, A2).

**14.** Control device according to one of the preceding claims, **characterised in that** when determining the current ($I_{load}$) by means of the measure recorded for the freewheeling time (F), the current detection unit (24) determines a value (W) from a table, with which value (W) the current ($I_{load}$) can be determined by multiplication.

## Revendications

**1.** Appareil de commande pour le fonctionnement d'un circuit de charge (12) qui comporte une charge inductive (M), comprenant un étage de commande (14) qui engendre un signal de commande à modulation de largeur d'impulsion (SPWM), lequel est interrompu par un intervalle de coupure de mesure (MAI) prévu, un étage de puissance (16) qui alimente le circuit de charge (12) avec un commutateur électronique (18) piloté par le signal de commande à modulation de largeur d'impulsion (SPWM), et un élément de roue libre (22), auquel un circuit de charge (12) peut être branché en parallèle,
**caractérisé en ce qu'**une unité de détection de courant (24) pour déterminer le courant ($I_{last}$) s'écoulant dans le circuit de charge avant l'intervalle de coupure de mesure (MAI) détecte la durée de roue libre (R) dans l'intervalle de coupure de mesure (MAI) et calcule le courant ($I_{last}$) à partir de cette durée.

**2.** Appareil de commande selon la revendication 1, **caractérisé en ce que** l'unité de détection de courant (24) détecte le temps de roue libre (F) au moyen d'un étage d'intégration (30) qui intègre une valeur de référence ($U_B$) sur le temps de roue libre (F).

**3.** Appareil de commande selon la revendication 2, **caractérisé en ce que**, pendant le temps pendant lequel la tension (U) dans le circuit de charge (12) est inférieure à zéro, l'étage d'intégration (30) est activé par un commutateur électronique (T1) commandé par la tension (U) dans le circuit de charge (12).

**4.** Appareil de commande selon la revendication 2 ou 3, **caractérisé en ce que** l'étage d'intégration (30) exécute une intégration d'une tension (UB) à titre de valeur de référence sur le temps de roue libre (F).

**5.** Appareil de commande selon l'une des revendications 2 à 4, **caractérisé en ce que** l'étage d'intégration (30) comprend un circuit RC (32).

**6.** Appareil de commande selon la revendication 5, **caractérisé en ce que** le chargement du condensateur (C) du circuit RC (32) est commandé via un commutateur électronique (T1) piloté par la tension (U) dans le circuit de charge (12).

**7.** Appareil de commande selon l'une des revendications 2 à 6, **caractérisé en ce que** la valeur ($U_{INT}$) mémorisée dans l'étage d'intégration (30) est effacée après achèvement de l'intervalle de coupure de mesure (MAI).

**8.** Appareil de commande selon la revendication 7, **caractérisé en ce que** la valeur ($U_{INT}$) mémorisée dans l'étage d'intégration (30) est effacée par le signal de commande à modulation de largeur d'impulsion (SPWM) qui apparaît à nouveau.

**9.** Appareil de commande selon la revendication 8, **caractérisé en ce que** l'effacement a lieu par un intervalle d'enclenchement du signal de commande à modulation de largeur d'impulsion (SPWM).

**10.** Appareil de commande selon l'une des revendications 2 à 9, **caractérisé en ce que** l'étage d'intégration (30) retient la valeur déterminée lors de l'intégration ($U_{INT}$) jusqu'à achèvement de l'intervalle de coupure de mesure (MAI).

**11.** Appareil de commande selon l'une des revendications précédentes, **caractérisé en ce que** lorsque la charge inductive dans le circuit de charge (12) est un moteur électrique (M), l'unité de détection de courant (24) destinée à déterminer le courant ($I_{last}$) qui s'écoule dans le circuit de charge (12) dans l'intervalle de coupure de mesure (MAI) mesure la durée du temps de roue libre (F) et la valeur de plateau ($U_{GMAX}$) de la tension du générateur (UG) après le temps de roue libre (F).

**12.** Appareil de commande selon la revendication 11, **caractérisé en ce que** l'unité de détection de courant (24) mesure la tension du générateur ($U_{GMAX}$) dans la plage du plateau (P) par plusieurs palpages de la tension (A1, A2).

**13.** Appareil de commande selon la revendication 12, **caractérisé en ce que** l'unité de détection de courant (24) exécute une moyenne des tensions (U) mesurées lors des plusieurs palpages de la tension (A1, A2).

**14.** Appareil de commande selon l'une des revendications précédentes, **caractérisé en ce que** l'unité de détection de courant (24) détermine à partir d'un tableau, lors de la détermination du courant ($I_{last}$) au moyen de la valeur détectée pour le temps de roue libre (F), une valeur (W) avec laquelle le courant ($I_{last}$) peut être déterminé par multiplication.

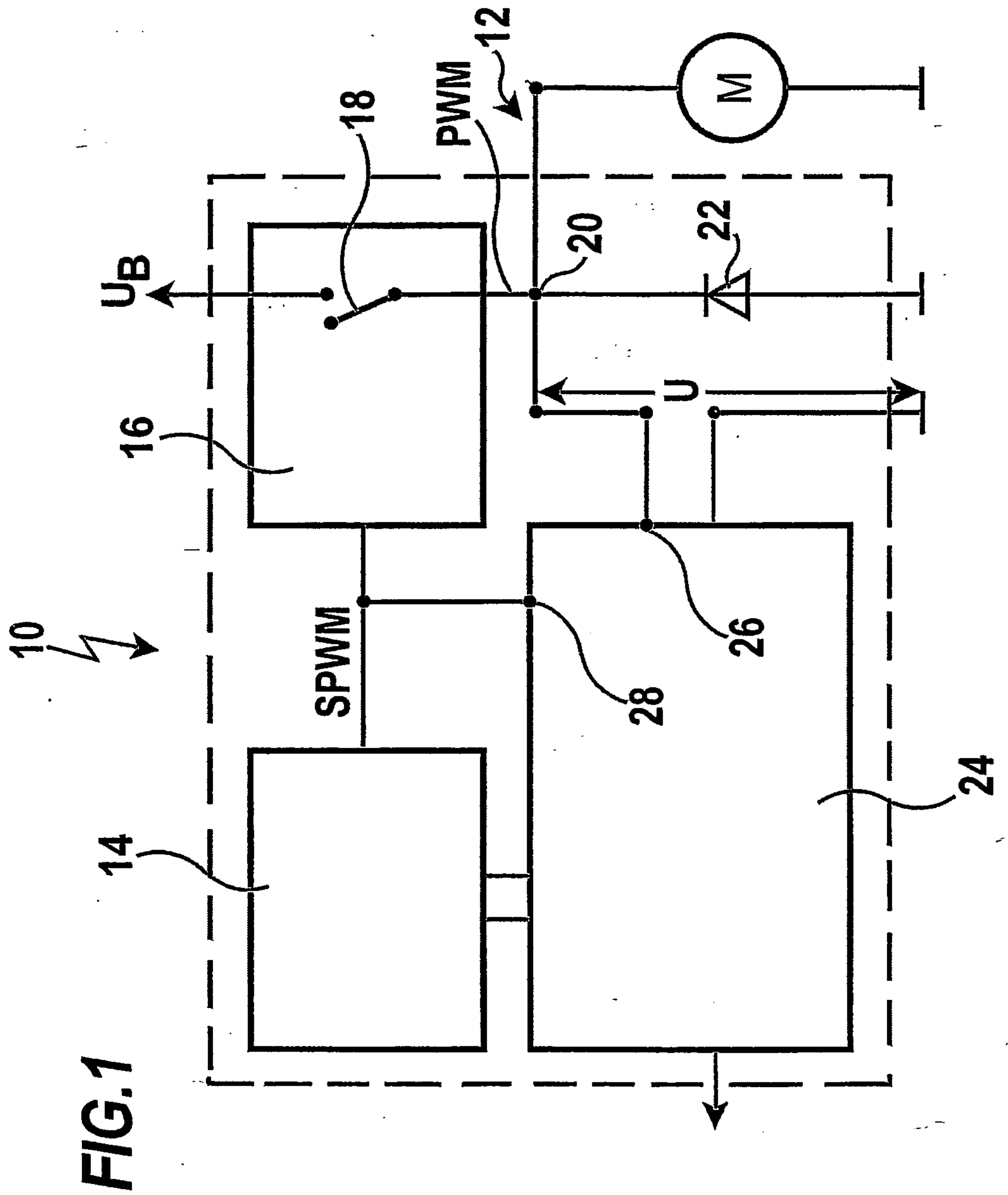


FIG.1

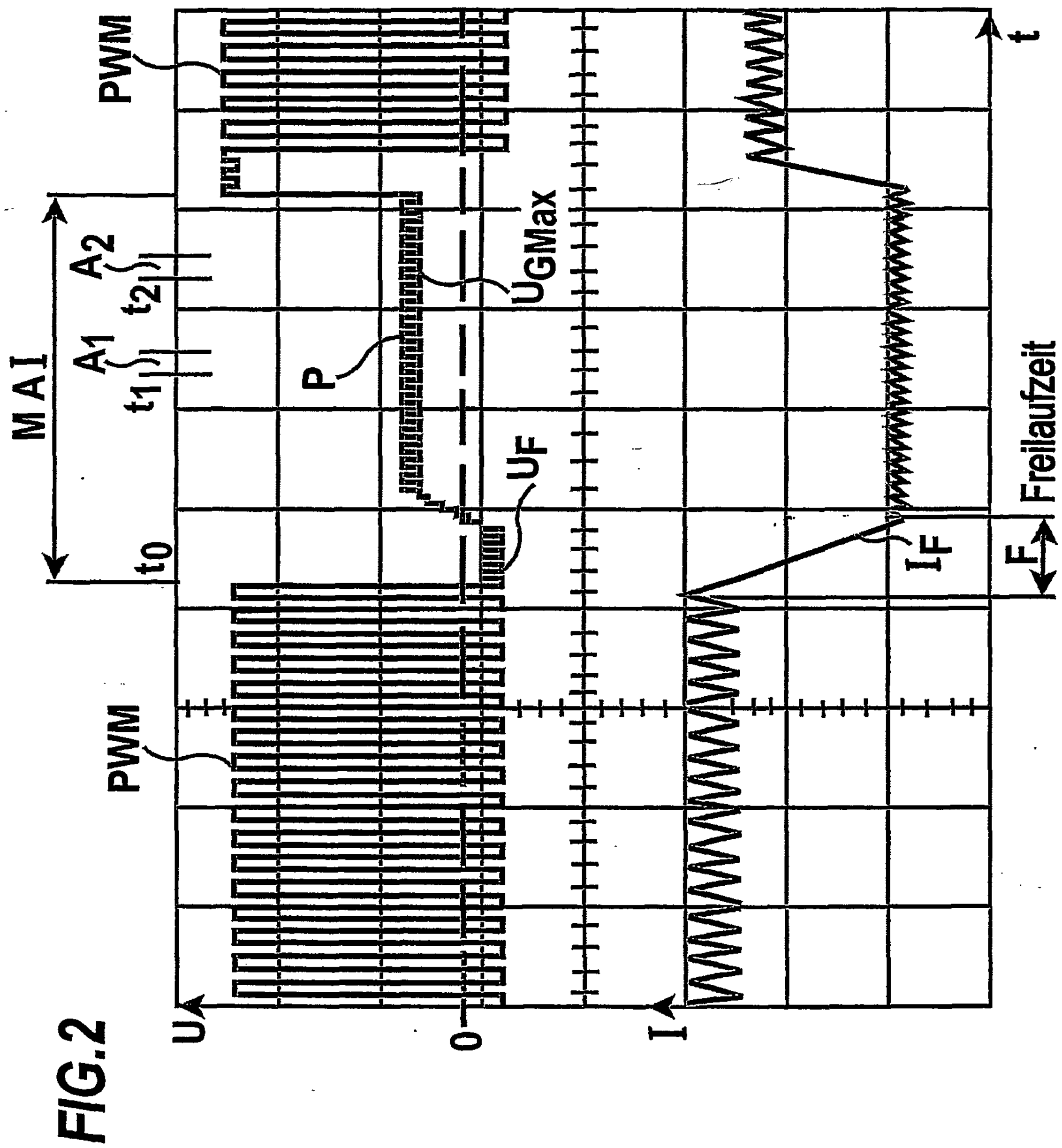


FIG.2

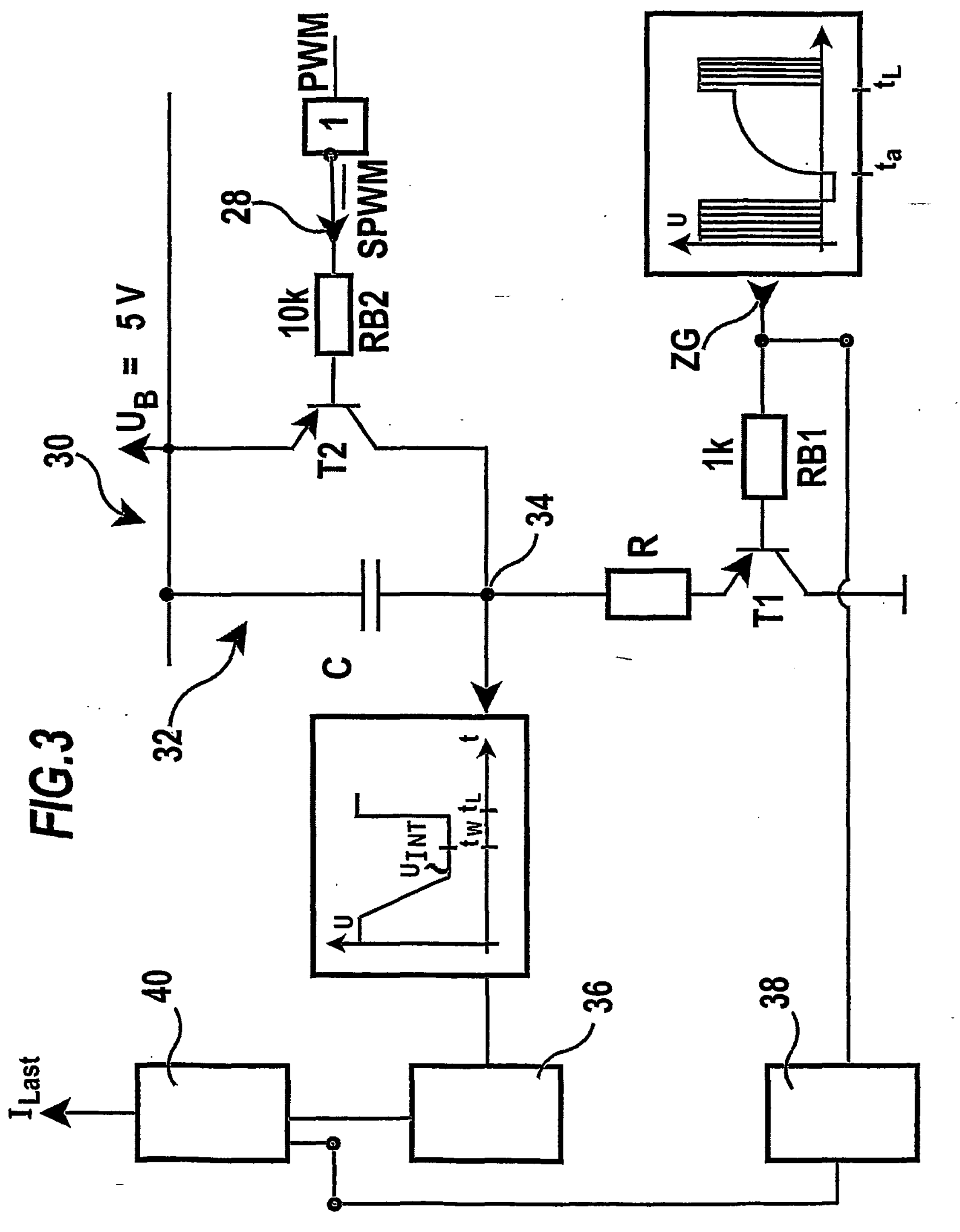
30
32
34
28
U_B = 5 V
PWM
1
SPWM
10k
RB2
T2
C
R
T1
1k
RB1
ZG
U
t_a
t_L
U_INT
t_W
t
40
36
38
I_Last

FIG.3

FIG.4

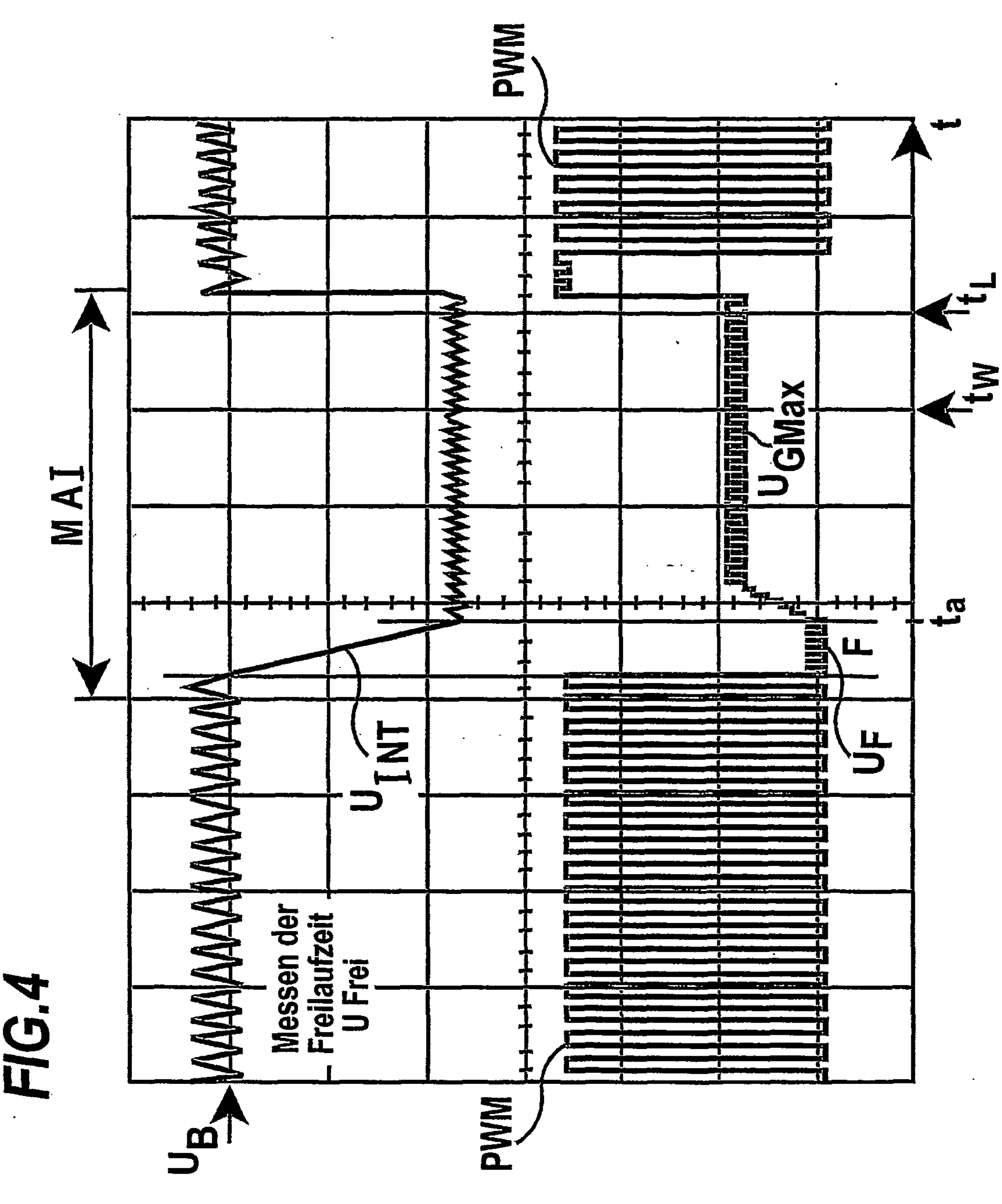
M A I
U_B
PWM
Messen der
Freilaufzeit
U Frei
U_INT
U_F
F
t_a
U_GMax
t_W
t_L
t
PWM

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 0855799 A2
- DE 19743346 A1